# EUROPEAN PATENT SPECIFICATION

(11) **EP 0 863 405 B1**
(45) Date of publication and mention of the grant of the patent: **11.10.2000**
(21) Application number: 97111640.5
(22) Date of filing: 09.07.1997
(51) Int. Cl.: G01R 29/10, H05K 9/00

(54) **Mounting plate for electromagnetic-wave absorbers**
Halteplatte für Absorber elektromagnetischer Wellen
Plaque de montage pour un absorbeur d'ondes électromagnétiques

(30) Priority: 06.03.1997 JP 7043397
(43) Date of publication of application: 09.09.1998
(73) Proprietor: Ten Co. Ltd., Nagoya-shi, Aichi-ken (JP)
(72) Inventor: Noda, Kenichi, c/o Ten Co. Ltd., Nagoyashi, Aichi-ken (JP)
(74) Representative: Hofstetter, Alfons J., Dr.rer.nat.

(56) References cited:
- EP-A- 0 660 123
- US-A- 5 210 373

## Description

### BACKGROUND OF THE INVENTION

### Field of the Invention

The present invention relates to mounting plates to be used for mounting electromagnetic-wave absorbers on an anechoic chamber or the like.

### Description of the Prior Art

Known as an electromagnetic-wave absorber is that which comprises two magnetic material plates having frequency characteristic of different specific-permeabilities attached to the front surface of a metal plate and a dielectric body such as an air layer or an insulating material provided between the magnetic material plates, as shown in the examined publication Toku-ko-sho 46-8625, for example.

For mounting the electromagnetic-wave absorber on the wall, ceiling and floor (those are called as the wall and the like, hereinafter), the electromagnetic-wave absorber to be mounted is disposed and secured with fixing screws so as to be brought into tight contact with another absorber mounted previously on the wall and the like. However, this fixing work took so much time that it was inefficient. In particular, for mounting the electromagnetic-wave absorber on the ceiling surface, it was inevitable that the absorber was pressed to the ceiling surface with one hand, and screwed with another hand, so that it was very inferior in workability.

### SUMMARY OF THE INVENTION

The present invention is directed to solve the above-described faults in the prior art, and the object is to provide a mounting plate for electromagnetic-wave absorbers which is capable of efficiently mounting electromagnetic-wave absorbers on the wall and the like in easy work so as to be brought into tight contact with each other, and capable of shortening the construction time.

### BRIEF DESCRIPTION OF THE DRAWINGS

FIG.1 is a perspective view of the whole of a mounting plate according to the present invention.

FIG.2 is a perspective view of the mounting plate attached with electromagnetic-wave absorbers.

FIG.3 is a sectional view taken on line III-III of FIG.2.

FIG.4 is a perspective view of the mounting plate through which electromagnetic-wave absorbers are mounted on the wall or the like.

FIG.5 is a perspective view of the assembled condition of the mounting plates.

FIG.6 is a sectional view taken on line VI-VI of FIG.5.

FIG.7 is a perspective view of another embodiment of the mounting plate attached with electromagnetic-wave absorbers.

FIG.8 is a perspective view of another embodiment of the mounting plate through which electromagnetic-wave absorbers are mounted on the wall or the like.

### DETAILED DESCRIPTION OF THE INVENTION

Referring to the accompanying drawings of the embodiments, the present invention will be described hereinafter.

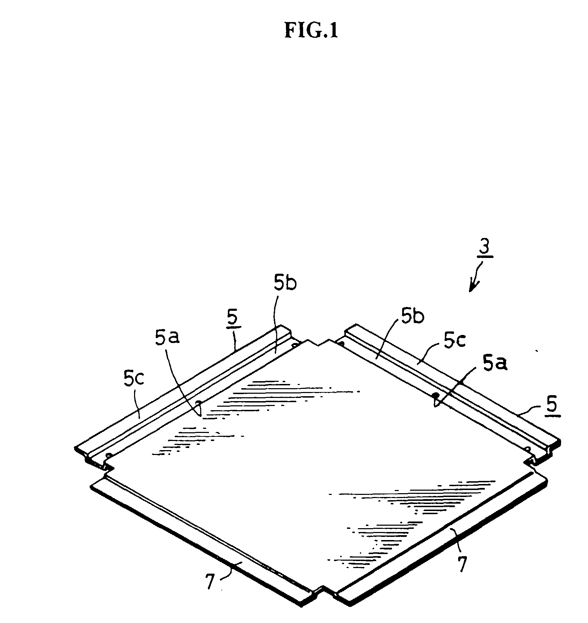

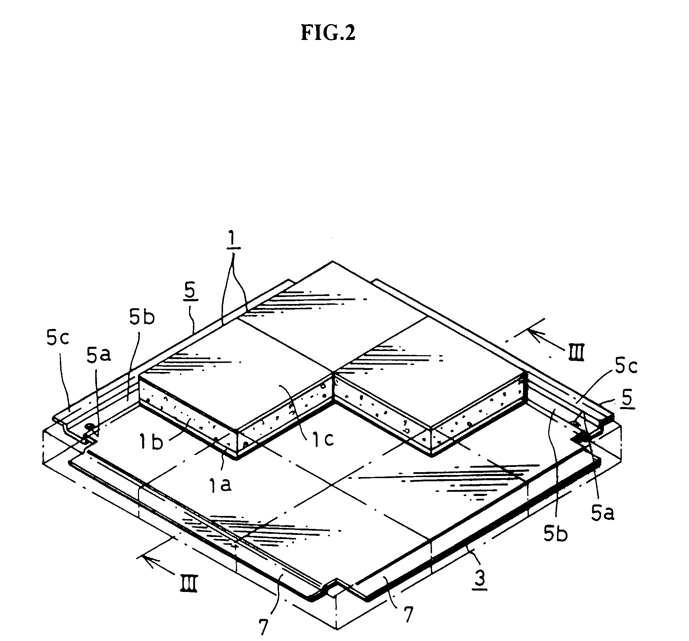

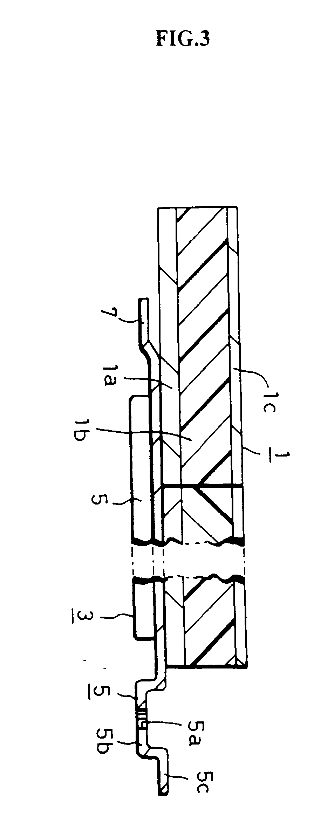

As shown FIG.1 to FIG.3, a mounting plate 3 for electromagnetic-wave absorbers 1 comprises a substantially square metal plate of about 1 mm thickness of which the four corners are cut out in a quadrangle of the same size. The mounting plate 3 is provided with fixing portions 5 formed along one pair of adjoining sides thereof, and also provided with engaging portions 7 formed along the other pair of adjoining sides thereof.

The fixing portion 5 comprises a fixing plate 5b and a retaining portion 5c. The fixing plate 5b is formed along the side of the metal plate by bending to descend from the side to the depth more than the thickness of the metal plate and thereafter to extend horizontally in a required width.

A plurality of screw holes 5a are provided in the fixing plate 5b. The retaining portion 5c is formed along the outer edge of the fixing plate 5b by bending to ascend from the edge to the height substantially equal to the top of the metal plate and thereafter to extend horizontally. Also, the engaging portion 7 is formed by bending to descend to the depth substantially equal to the thickness of the metal plate and thereafter to extend horizontally.

Attached on the top surface of the mounting plate 3 is the electromagnetic-wave absorbers 1 which is in the size equal to that of the plate 3 so that the one pair of adjoining sides of the absorbers 1 may accord to the corresponding inner edges of the fixing portions 5, and so that the other pair of adjoining sides of the absorbers 1 may project from the inner edge of the engaging portion 7 by the width of the fixing portions 5.

The electromagnetic-wave absorber 1 is formed in the structure comprising a first magnetic body 1a such as the sintered ferrite plate of about 3 to 7 mm thickness and a required specific permeability, a second magnetic body 1c such as the sintered ferrite plate of about 1 to 2 mm thickness and the specific permeability different from the first magnetic body 1a, and a dielectric body 1b, such as the foamed-resin plate of about 20 to 50 mm thickness and a required dielectric constant, layer of air and the like, which is laid between the first and the second magnetic body 1a, 1c.
Also, in addition to the above-described three-layer structure, the electromagnetic-wave absorber 1 may be a grid-formed sintered- ferrite plate in which a number of gap portions are arranged at regular intervals in the vertical and the lateral direction.

Moreover, although the electromagnetic-wave absorber 1 described above is formed in one sheet of the size equal to the mounting plate 3, it may be a structure comprising a plurality of sheets which are in shapes similar to but smaller than the mounting plate 3 and can be assembled together into the size equal to the mounting plate 3 when those are disposed adjoining one another.

Next, the mounting process of the electromagnetic-wave absorber 1 by use of the above-described mounting plate 3 will be described hereinafter.

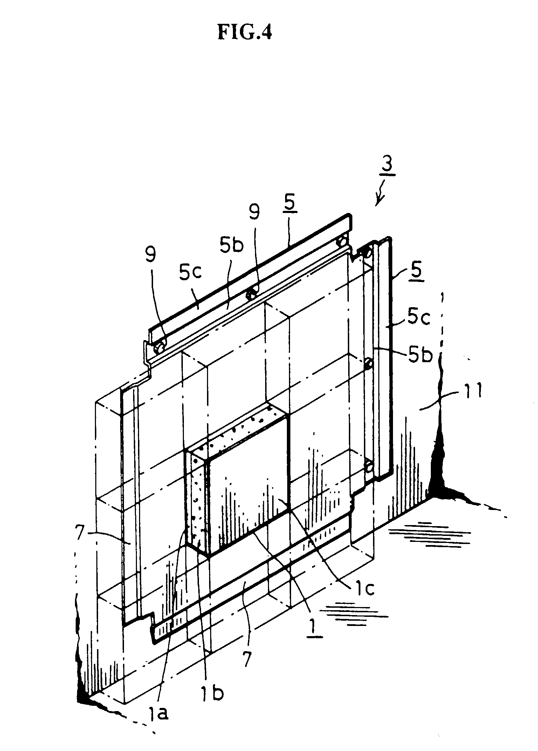

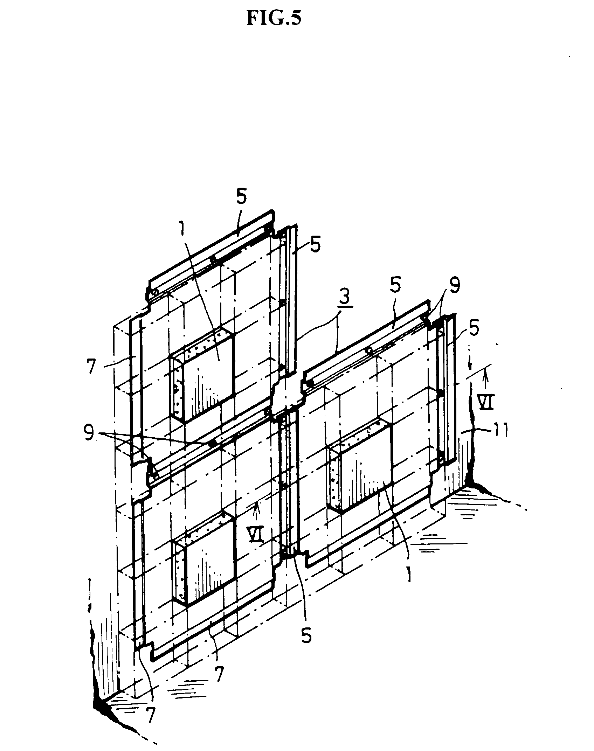

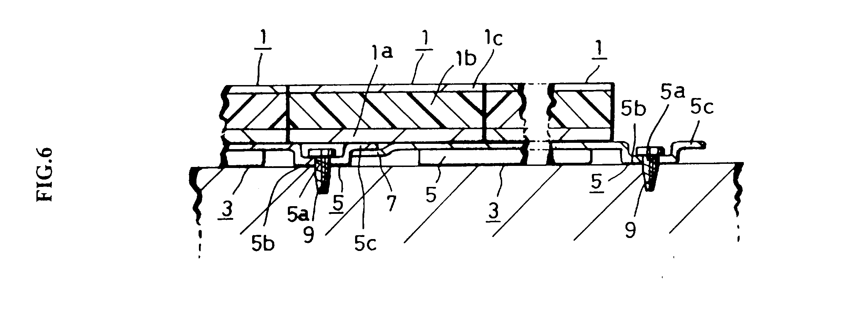

As shown FIG.4 to FIG.6, before the installation of the electromagnetic-wave absorbers 1, reflector metal-plate (not shown) are previously attached to all over the wall and the like 11 of the anechoic chamber. Then, the mounting plate 3 having the electromagnetic-wave absorbers 1 attached thereon is secured to the wall and the like 11 by fastening the fixing screws 9 inserted in the screw holes 5a. At this time, the engaging portions 7 to face the fixing portions 5 are slightly floating above the wall and the like 11.

Next, inserted into the respective retaining portions 5c of the mounting plate 3 screwed to the wall and the like 11 are the respective engaging portions 7 of the mounting plate 3 to be disposed adjoining the screwed mounting plate 3, and in this engaged condition the mounting plate 3 to be fixed is screwed to the wall and the like 11 by fastening the fixing screws 9 in the screw holes 5a thereof. At this time, the electromagnetic- wave absorber 1 attached to the top of the mounting plate 3 is substantially in the same size as that of the mounting plate 3 and the two sides corresponding to the engaging portions 7 are projected by the width of the respective fixing portions 5. Consequently, when the engaging portions 7 are engaged with the corresponding retaining portions 5c and both the mounting plates 3 are disposed adjoining each other, both the electromagnetic-wave absorbers 1 are brought into tight contact with each other.

Next, similarly to the above-described process, the engaging portions 7 of the mounting plate 3 to be disposed are inserted into the retaining portions 5c of the respective mounting plates 3 screwed to the wall and the like 11, and in this engaged condition the mounting plate 3 to be fixed is screwed to the wall and the like 11. Thus, a number of the electromagnetic-wave absorbers 1 can be mounted on the wall or the like 11 in the tight contact.

Another embodiment of the present invention is as follows.

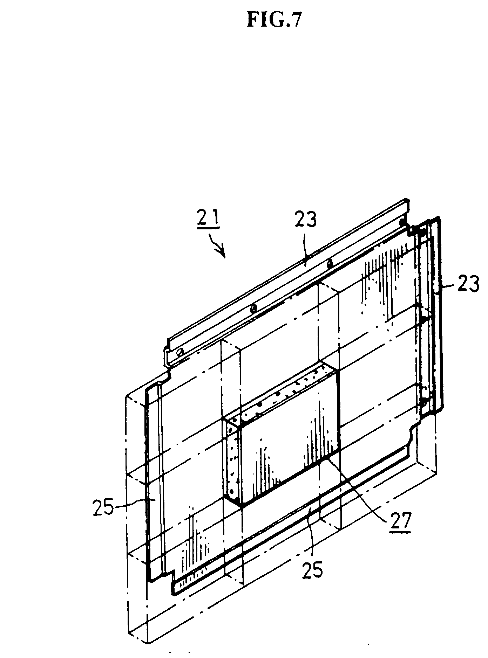

As shown in FIG.7, a mounting plate 21 comprises a vertical or horizontal rectangular metal plate of which the four corners are cut out in the same size. The mounting plate 21 is provided with fixing portions 23 formed along one pair of adjoining sides thereof, and also provided with engaging portions 25 formed along the other pair of adjoining sides thereof. Since the fixing portion 23 and the engaging portion 25 are formed in the same structures as those of the fixing portion 5 and the engaging portion 7 of the above-described embodiment, the detailed description is omitted.

Attached on the top surface of the mounting plate 21 is the electromagnetic-wave absorber 27 which is in the size equal to that of the plate 21 so that the one pair of adjoining sides of the absorber 27 may accord to the corresponding inner edges of the fixing portions 23, and so that the other pair of adjoining sides of the absorber 27 may project respectively from the inner edges of the engaging portion 25 by the width of the fixing portion 23.

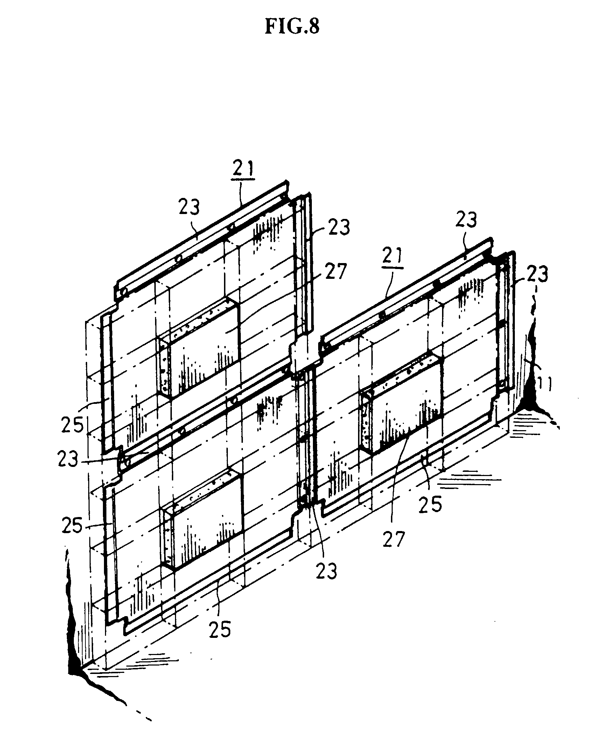

Then, as shown in FIG.8, the fixing portions 23 of the mounting plate 21 having the electromagnetic-wave absorber 27 attached thereon are secured to the wall and the like 11 by fastening the fixing screws 29. Thereafter, the engaging portions 25 of the mounting plate 3 to be disposed are engaged with the corresponding retaining portions 23a of the fixing portions 23 and screwed to the wall surface or the like 11, so that the electromagnetic-wave absorbers 1 of the respective mounting plates 21 are brought into tight contact with one another.

## Claims

1. A mounting plate (3) for electromagnetic-wave absorbers (27) comprising:
a substantially quadrangular metal plate of which the four corners are cut out in the same size; (S)
said metal plate provided with fixing portions (5) formed along one pair of adjoining sides of the metal plate in section descending from the side to the depth more than the thickness of the metal plate and extending horizontally;
the recess of said fixing portion provided with through holes (5a) formed therein for fixing screws (9);
said metal plate provided with retaining portions (5c) formed along the outer edges of said fixing portions in section ascending from the edge to the height equal to the top of the metal plate and extending horizontally;
said metal plate provided with engaging portions (7) formed along the other pair of adjoining sides of the metal plate in section descending from the side to the depth at least equal to the thickness of the metal plate and extending horizontally, which are capable of engaging with said retaining portions (5c); and
said metal plate having a quadrangular electromagnetic- wave absorber (27) attached on the top thereof, of which the size is equal to that of the metal plate, so that a pair of adjoining sides of said absorber may accord with the inner edges of said fixing portion (23).

2. A mounting plate for electromagnetic-wave absorbers as defined in claim 1, wherein said metal plate is in a square form.

3. A mounting plate for electromagnetic-wave absorbers as defined in claim 1, wherein said metal plate is in a rectangular form.

4. A mounting plate for electromagnetic-wave absorbers as defined in claim 1, wherein said electromagnetic-wave absorber is in the size equal to that of said metal plate and formed in a single sheet.

5. A mounting plate for electromagnetic-wave absorbers as defined in claim 1,
wherein said electromagnetic-wave absorber comprises a plurality of sheets in the similar figure which are capable of assembling into the size equal to said metal plate.

## Patentansprüche

1. Montageplatte (3) für Absorber (27) für elektromagnetische Wellen, welche folgendes umfaßt:
eine im wesentlichen rechteckige Metallplatte, deren vier Ecken in derselben Größe ausgeschnitten sind;
wobei die Metallplatte mit Befestigungsteilen (5) versehen ist, die entlang eines Paars von aneinandergrenzenden Seiten der Metallplatte ausgebildet sind, im Querschnitt von der Seite in die Tiefe um mehr als die Dicke der Metallplatte abfallen und sich horizontal erstrecken;
die Vertiefung des Befestigungsteils mit Durchgangslöchern (5a) versehen ist, die zum Befestigen von Schrauben (9) darin ausgebildet sind;
die Metallplatte mit Halteteilen (5c) versehen ist, die entlang der Außenkanten der Befestigungsteile ausgebildet sind, im Querschnitt von der Kante in die Höhe gleich der Oberseite der Metallplatte ansteigen und sich horizontal erstrecken;
die Metallplatte mit Eingriffsteilen (7) versehen ist, die entlang des anderen Paars von aneinandergrenzenden Seiten der Metallplatte ausgebildet sind, im Querschnitt von der Seite in die Tiefe zumindest gleich der Dicke der Metallplatte abfallen und sich horizontal erstrecken, welche in der Lage sind, in die Halteteile (5c) einzugreifen; und
die Metallplatte einen rechteckigen Absorber (27) für elektromagnetische Wellen aufweist, der auf deren Oberseite befestigt ist, dessen Größe gleich jener der Metallplatte ist, so daß ein Paar von aneinandergrenzenden Seiten des Absorbers den Innenkanten des Befestigungsteils (23) entsprechen kann.

2. Montageplatte für Absorber für elektromagnetische Wellen nach Anspruch 1, wobei die Metallplatte eine quadratische Form aufweist.

3. Montageplatte für Absorber für elektromagnetische Wellen nach Anspruch 1, wobei die Metallplatte eine rechteckige Form aufweist.

4. Montageplatte für Absorber für elektromagnetische Wellen nach Anspruch 1, wobei der Absorber für elektromagnetische Wellen die gleiche Größe wie jene der Metallplatte aufweist und in einer einzigen Fläche ausgebildet ist.

5. Montageplatte für Absorber für elektromagnetische Wellen nach Anspruch 1, wobei der Absorber für elektromagnetische Wellen eine Vielzahl von Flächen mit ähnlicher Gestalt umfaßt, die zum Zusammensetzen in die Größe gleich der Metallplatte in der Lage sind.

## Revendications

1. Plaque de montage (3) pour des absorbeurs (1) d'ondes electromagnétiques, comprenant:
une plaque métallique essentiellement quadrangulaire dont les quatre coins sont découpés de même taille;
ladite plaque de montage étant pourvue de parties de fixation (5) formées le long d'une paire de faces latérales adjacentes de la plaque métallique qui descend en section transversale de la face latérale vers le bas plus que l'épaisseur de la plaque métallique, et qui s'étend horizontalement;
le creux de ladite partie de fixation étant pourvu de perforations (5a) ménagées en celui-ci pour recevoir des vis de fixation (9);
ladite plaque métallique étant pourvue de parties de rétention (5c) formées le long des bords extérieurs desdites parties de fixation et ascendant en section transversale du rebord à la hauteur égale à la face supérieure de la plaque métallique, et s'étendant horizontalement;
ladite plaque métallique étant pourvue de parties d'engagement (7) formées le long de l'autre paire de faces latérales adjacentes de la plaque métallique descendant en section transversale de la face latérale vers le bas au moins égale à l'épaisseur de la plaque métallique, et s'étendant horizontalement, et qui sont capables de se mettre en prise avec lesdites parties de rétention (5c); et
ladite plaque métallique ayant attaché sur sa face supérieure un absorbeur (1) d'ondes magnétiques quadrangulaire dont la taille est égale à celle de la plaque métallique, afin qu'une paire de faces latérales adjacentes dudit absorbeur puisse correspondre aux bords intérieurs de ladite partie de fixation (23).

2. Plaque de montage pour des absorbeurs d'ondes electromagnétiques selon la revendication 1, la plaque métallique ayant une forme quadratique.

3. Plaque de montage pour des absorbeurs d'ondes electromagnétiques selon la revendication 1, la plaque métallique ayant une forme rectangulaire.

4. Plaque de montage pour des absorbeurs d'ondes electromagnétiques selon la revendication 1, la plaque métallique ayant une forme identique à ladite plaque métallique et étant réalisée en une seule couche.

5. Plaque de montage pour des absorbeurs d'ondes electromagnétiques selon la revendication 1, l'absorbeur d'ondes electromagnétiques comprenant une pluralité de couches de figure similaire qui peuvent s'assembler en une taille égale à ladite plaque métallique.
